# FASCICULE DE BREVET EUROPEEN

(11) **EP 2 195 643 B1**
(45) Date de publication et mention de la délivrance du brevet: **04.07.2018**
(21) Numéro de dépôt: 08775286.1
(22) Date de dépôt: 22.07.2008
(51) Int. Cl.: G01N 21/66, H01J 37/32, H05H 1/30

(54) **SYSTEME D'ANALYSE DE GAZ A BASSE PRESSION PAR SPECTROSCOPIE D'EMISSION OPTIQUE**
SYSTEM ZUR ANALYSE EINES NIEDERDRUCKGASES MITTELS OPTISCHER EMISSIONSSPEKTROSKOPIE
SYSTEM FOR ANALYSING A LOW PRESSURE GAS BY OPTICAL EMISSION SPECTROSCOPY

(30) Priorité: 27.08.2007 FR 0757203
(43) Date de publication de la demande: 16.06.2010
(73) Titulaire: Pfeiffer Vacuum, 74000 Annecy (FR)
(72) Inventeur: BOUNOUAR, Julien, 74000 ANNECY (FR); HADJ-RABAH, Smail, F-74000 Annecy (FR)
(74) Mandataire: Croonenbroek, Thomas Jakob
(86) Numéro de dépôt international: PCT/EP2008/059614
(87) Numéro de publication internationale: WO 2009/027156

(56) Documents cités:
- WO-A-00/31773
- GB-A- 2 441 582
- US-A- 2 457 781
- US-A- 3 382 389
- US-A1- 2003 190 012
- REISS K H: "Die Lichtemission von Hochvakuumgasentladungen" ZEITSCHRIFT FÜR ANGEWANDTE PHYSIK, vol. 7, 1955, pages 433-437, XP008090968 Allemagne
- BECK A H, BRISBANE A D: "A cylindrical magnetron ionisation gauge" VACUUM, vol. 2, 1952, pages 137-146, XP002478311

## Description

La présente invention se rapporte à un système d'analyse de gaz à une pression très basse, de l'ordre d'un vide secondaire (10⁻³ à 10⁻⁸ mbar), en utilisant la spectroscopie d'émission optique. La présente invention se rapporte aussi à un procédé d'analyse d'effluents gazeux provenant d'une enceinte sous pression contrôlée. L'invention concerne enfin un équipement industriel comprenant au moins une enceinte à pression contrôlée, et un système d'analyse des gaz en communication avec l'enceinte à pression contrôlée.

Les progrès réalisés, lors de ces dernières années dans l'industrie du semi-conducteur, sont essentiellement liés à l'accroissement de l'intégration de circuits électroniques sur des composants de quelques millimètres carrés ; ceci sur des substrats de silicium de plus en plus grand (diamètre de 200 mm à 300 mm).

Les étapes technologiques, nécessaires à la réalisation de tels circuits, sont nombreuses (jusqu'à 400). Parmi elles, les étapes de traitement sous vide, jouent un rôle essentiel, tant par leurs capacités à produire de façon continue tout au long du procédé de fabrication que part leurs fonctions à respecter les critères géométriques du composant.

La mise en place d'un système d'analyse de procédé in situ, identifie les défauts dès leurs créations, réduisant le temps de réaction pendant lequel un nombre important de lots peuvent être produit. De ce fait une demande importante apparaît pour le suivi et le contrôle in situ et en temps réel des procédés de fabrication de semi-conducteur par plasma, réalisés sous vide.

On connaît l'utilisation de la spectroscopie par émission optique sur des équipements de fabrication de semi-conducteurs. La spectrométrie par émission est utilisée pour effectuer la détection de fin d'attaque dans les procédés de gravure des circuits ou composants semi-conducteurs. Le plasma analysé est celui généré par le réacteur de l'équipement, ce dernier est simplement instrumenté par un spectromètre d'émission qui analyse la lumière du procédé de gravure, permettant un contrôle des étapes du procédé lui-même.

Cependant on cherche à utiliser la spectrométrie par émission optique pour contrôler, non pas les étapes du procédé de fabrication ou de gravure de l'équipement semi-conducteur, mais tous les constituants gazeux de l'environnement sous vide de l'équipement. Un spectromètre par émission optique, après diffraction de la lumière, analyse en temps réel l'évolution des radiations émises par les atomes, molécules et ions, excitées par les électrons libres du plasma.

Or les techniques actuellement connues ne permettent de réaliser ce type de mesure qu'en vide grossier (de 1000 mbar à 1 mbar) ou en vide primaire (de 1 mbar à 10⁻³ mbar).

Le document EP-1 022 559 décrit un équipement comprenant une enceinte contenant des gaz à une pression comprise entre 0,1 mbar et 1000 mbar, et un système pour l'analyse de ces gaz comportant un dispositif d'ionisation des gaz et un dispositif d'analyse des gaz ionisés par spectroscopie d'émission optique. Le dispositif d'ionisation comprend une source radiofréquence de plasma, de type ICP ou micro-onde.

Le document EP-1 131 670 décrit un dispositif de contrôle par spectroscopie d'émission optique des espèces gazeuses provenant d'une enceinte. Le dispositif comprend une chambre comportant une zone de formation d'un plasma et un moyen d'analyse de la radiation lumineuse émise par le plasma. Un capteur de radiation, tel qu'une fibre optique, est placé à proximité de la zone de formation du plasma. Le plasma est formé au moyen d'un générateur de puissance associé à une antenne d'excitation générant des ondes électromagnétiques. Un champ électrique ou magnétique est utilisé pour former une barrière afin d'écarter les particules ionisées de l'interface transparente à la radiation.

Le document WO-00/31 773 décrit un dispositif pour la détermination de la composition d'un effluent gazeux provenant d'une chambre de procédé sous vide. Le dispositif comprend une cellule dans laquelle est formé le plasma et un détecteur, placé derrière une fenêtre, pour recueillir la lumière émise par le plasma et la transmettre à un analyseur de spectre optique. Le plasma est généré par un champ électrique produit par un générateur de courant alternatif, tel qu'un générateur commercial du type utilisé dans les lampes fluorescentes ou d'un générateur de microondes du type magnétron. Selon un mode de réalisation particulier, une cathode pleine est disposée coaxialement à la direction du flux gazeux et isolée de la paroi conductrice de la cellule servant d'anode. La publication par K. H. Reiss "Die Lichtemission von Hochvakuumgasentladungen" Zeitschrift f. angew. Physik, vol. 7, pages 433-437 (1955) divulgue l'utilisation d'une source de plasma pour l'analyse de gaz à une pression de l'ordre d'un vide secondaire.

Dès que la pression dans la chambre de procédé devient inférieure à 10⁻³ mbar, les systèmes actuels ne sont plus capables d'exciter suffisamment les gaz afin de générer une lumière exploitable pour une mesure spectroscopique. Le problème est donc de générer une radiation de lumière issue d'un plasma suffisamment lumineuse et suffisamment concentrée pour pouvoir réaliser en temps réel (inférieur à une seconde) une analyse d'espèces gazeuses sous vide secondaire (de 10⁻³ à 10⁻⁷ mbar) par spectrométrie d'émission optique.

Cependant cette mesure doit aussi pouvoir être effectuer de manière reproductible pendant toute la durée nécessaire à l'analyse.

L'objet de la présente invention est un système d'analyse de gaz à une pression de l'ordre d'un vide secondaire. Le système d'analyse comporte un dispositif selon l'objet de la revendication 1. L'anode doit être centrée dans le trou central du disque sinon l'anneau de lumière ne parvient pas à se créer et la mesure est alors impossible à basse pression.

Plus précisément la cathode comporte un disque perforé comprenant des trous traversants périphériques entourant le trou central traversant.

Selon une forme d'exécution de l'invention, le diamètre d de la cavité est moindre que le diamètre D du volume cylindrique, et il est ajustable en fonction de la pression des gaz à analyser.

Selon une autre forme d'exécution, l'anode est isolée de la cathode par un support en matériau diélectrique fixé sur le disque de la cathode.

Selon encore une autre forme d'exécution, l'anode est isolée de la cathode par un support en matériau diélectrique inséré dans le trou central du disque de la cathode.

Avantageusement, dans ce dernier cas, le système comporte en outre un dispositif de régulation permettant d'asservir la tension d'alimentation de l'anode à la variation de pression des gaz à analyser.

Le système collecteur comporte au moins une lentille convergente, qui est disposée de telle sorte que l'axe optique de la lentille et l'axe des électrodes soient de préférence confondus. L'extrémité de la cavité opposée au volume cylindrique est fermée par un hublot transparent à la radiation lumineuse émise par le plasma.

Selon une variante l'extrémité de la cavité opposée au volume cylindrique est fermée par une lentille transparente à la radiation lumineuse émise par le plasma. Dans ce cas la lentille remplit aussi la fonction du hublot.

Afin de minimiser la pollution du hublot ou de la lentille, la cavité est disposée de préférence à l'extrémité du volume cylindrique de manière à ce que le trajet de la radiation lumineuse qui la traverse soit de même direction et de sens opposé au flux des gaz pompés.

La présente invention a aussi pour objet un équipement de fabrication de semi-conducteurs par plasma selon l'objet de la revendication 8. D'autres caractéristiques et avantages de la présente invention apparaîtront à la lecture de la description qui suit d'un mode de réalisation, donné bien entendu à titre illustratif et non limitatif, et dans le dessin annexé sur lequel
- la figure 1 représente schématiquement un équipement industriel comprenant un système d'analyse de gaz selon l'invention,
- la figure 2 montre le dispositif d'ionisation des gaz selon un mode de réalisation de l'invention,
- la figure 3 est une vue détaillée du disque de la cathode du dispositif d'ionisation des gaz,
- la figure 4, analogue à la figure 2, montre le dispositif d'ionisation des gaz selon un autre mode de réalisation de l'invention,
- la figure 5 représente la chaine d'acquisition optique du dispositif d'analyse des gaz ionisés,
- la figure 6 est une vue détaillée de la zone de recueil de la radiation lumineuse émise par le plasma.

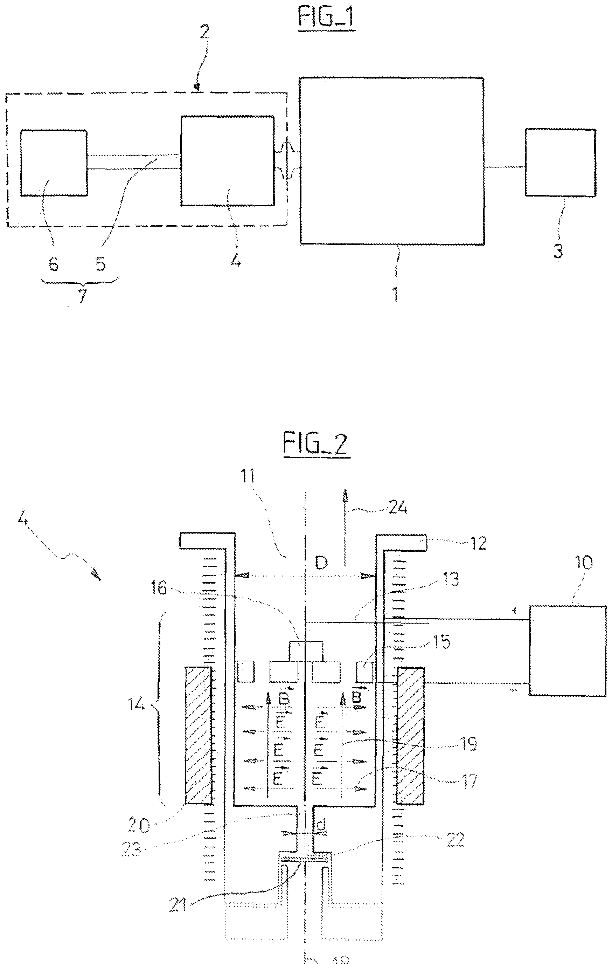

L'équipement industriel représenté sur la figure 1 comprend au moins une enceinte **1,** dont la pression est contrôlée, et un système d'analyse des gaz **2** en communication avec l'enceinte **1.** Un vide secondaire Pᵥ (de 10⁻³ à 10⁻⁸ mbar) est ménagé dans l'enceinte **1** au moyen d'une ligne de vide comportant un groupe de pompage **3** primaire et secondaire. Le système d'analyse de gaz comprend un dispositif d'ionisation des gaz **4** au moyen d'une source de plasma, un système collecteur optique **5** qui permet de recueillir la lumière et de l'acheminer vers un dispositif d'analyse **6.** Le collecteur optique **5** et le dispositif d'analyse **6** composent une chaîne d'acquisition optique **7.**

La figure 2 montre plus précisément le dispositif d'ionisation des gaz **4** du système **2** d'analyse de gaz selon l'invention. Le dispositif d'ionisation **4** comporte une source de plasma et un générateur **10** de courant continu.

Le dispositif d'ionisation **4** comporte un volume **11** cylindrique, de diamètre D et délimité par des parois **12** en un matériau conducteur résistant au vide, tel que par exemple l'acier inoxydable. Le dispositif d'ionisation **4** est raccordé à l'enceinte **1** sous vide secondaire. La mise sous vide du volume **11** peut être réalisée grâce aux moyens de pompage **3** de l'enceinte **1,** elle-même sous vide. Un plasma est généré à l'intérieur de ce volume **11** afin de permettre d'analyser les espèces gazeuses présentes dans l'enceinte **1.**

La source de plasma est formée d'une anode **13** (pôle +) et d'une cathode **14** (pôle -) respectivement connectées aux pôles positif et négatif du générateur **10** de tension continue. La cathode **14** comprend des parois **12** qui délimitent le volume cylindrique **11** de diamètre D, et un disque **15** perforé. L'anode **13** de type filaire est placée au centre de la cathode **14** dont elle est isolée par un support **16** en matériau diélectrique à faible taux de dégazage, comme par exemple une céramique, posé sur la surface du disque **15** de la cathode **14.**

Le générateur **10** applique entre l'anode **13** (chargée positivement) et la cathode **14** (chargée négativement) une forte différence de potentiel, de l'ordre de 3000 Volts, qui génère un champ électrique E **17** intense de direction transverse par rapport à l'axe **18** de la source de plasma. Ce champ **17** permet de créer un plasma par génération et accélération d'un flux d'électrons de la cathode **14** vers l'anode **13** afin d'exciter et ioniser les molécules gazeuses provenant de l'enceinte **1.** Pour obtenir un plasma exploitable, on lui adjoint un champ magnétique B **19** d'intensité constante, environ 100 mT, et de direction donnée, perpendiculaire au champ électrique **17** et parallèle à l'axe **18.** Le champ magnétique **19** est généré par au moins un aimant **20** torique permanent entourant le volume cylindrique **11.** La présence d'un champ magnétique B **19** couplé au champ électrique E **17** permet d'augmenter fortement l'excitation des molécules de gaz du plasma. Ainsi la source plasma est générée par l'action combinée d'un champ électrique **17** constant entre deux électrodes **13, 14** à géométrie cylindrique et d'un champ magnétique **19** constant, parallèle à la surface des électrodes **13, 14** et orthogonal au champ électrique **17.**

Le plasma formé est utilisé comme source de lumière. La lumière émise, provenant de la désexcitation des molécules caractéristiques des gaz présents, devient ainsi suffisante pour permettre une mesure en temps réel (inférieur à 1 seconde) en vide secondaire.

Cependant la génération d'un plasma sous vide dans le volume **11** entraine le craquage moléculaire des molécules (notamment des hydrocarbures) qui sont présentes dans l'enceinte **1** sous vide dont on doit analyser les gaz. Une fois craquées, ces molécules ont tendance à se fixer par des liaisons fortes sur les parois **12** du volume **11** où est réalisé le plasma, et sont donc difficiles à décrocher. La source de plasma joue alors le rôle d'un piège pour ces molécules, et contribue ainsi à décontaminer l'enceinte et les lignes de pompage. Toutefois la présence de ce piège est néfaste pour le dispositif optique d'analyse.

Pour récolter suffisamment de lumière permettant une détection et une analyse significative des gaz présents dans l'enceinte **1,** il est indispensable de réduire la distance entre le plasma et le dispositif d'analyse ce qui entraine une pollution rapide de ce dispositif le rendant opaque à la lumière. Une mesure correcte devient rapidement difficile, voire impossible, et ne peut être reproduite dans les mêmes conditions.

Pour remédier à ce problème, la présente invention propose de placer un hublot **21,** permettant de laisser passer la lumière émise par le plasma, à l'extrémité **22** d'une cavité cylindrique **23** opposée à l'extrémité de la cavité adjacente à la source plasma dans le volume **11.** La cavité cylindrique **23** a une conductance moindre que celle du volume cylindrique **11** dans lequel est placée la source de plasma. Par exemple la cavité **23** peut avoir un diamètre d moindre que le diamètre D du volume **11.** Par exemple encore la cavité **23** peut avoir une longueur au moins égale à 1 cm et un diamètre d au moins deux fois plus petit que le diamètre D du volume **11.** De préférence, la diamètre d de la cavité **23** est réglable en fonction de la pression de travail : plus la pression de travail est élevée et la pollution importante, plus le diamètre d de la cavité **23** doit être petit. En pratique, le diamètre d de la cavité **23** est réalisé dès le départ avec la valeur maximale compatible avec fonctionnement du dispositif d'analyse de gaz à basse pression. Puis en fonction de l'élévation de la pression de travail, des inserts de même forme que l'intérieur de la cavité pourront être introduits en force dans la cavité **23** de manière à réduire son diamètre d.

A l'intérieur de cette cavité **23,** il n'y a ni champ électrique E, ni champ magnétique B. L'éloignement du hublot **21** par rapport à la source plasma et l'absence de champs dans la cavité **23** permettent de piéger les molécules polluantes avant qu'elles n'atteignent le hublot **21.** Pour minimiser le problème de la pollution du hublot **21,** la cavité **23** est disposée avantageusement de manière à ce que le trajet de la radiation lumineuse soit de même direction et de sens opposé au flux des gaz pompés **24.** En effet une dépression est générée par le groupe de pompage **3** de l'enceinte **1** sous vide, à l'intérieur de laquelle se trouvent les gaz à analyser, et simultanément le plasma provoque une légère surpression. La différence de pression qui en résulte entraîne un flux particulaire des produits du plasma vers le groupe de pompage **3,** limitant ainsi la pollution du hublot **21.**

Selon une variante de réalisation, un chauffage extérieur (non représenté) peut être rajouté autour de la cavité **23,** ce qui va crée un effet de diffusion thermique des molécules centrifuge dans la cavité **23,** et améliorer encore l'effet barrière lié à la faible conductance de la cavité **23.**

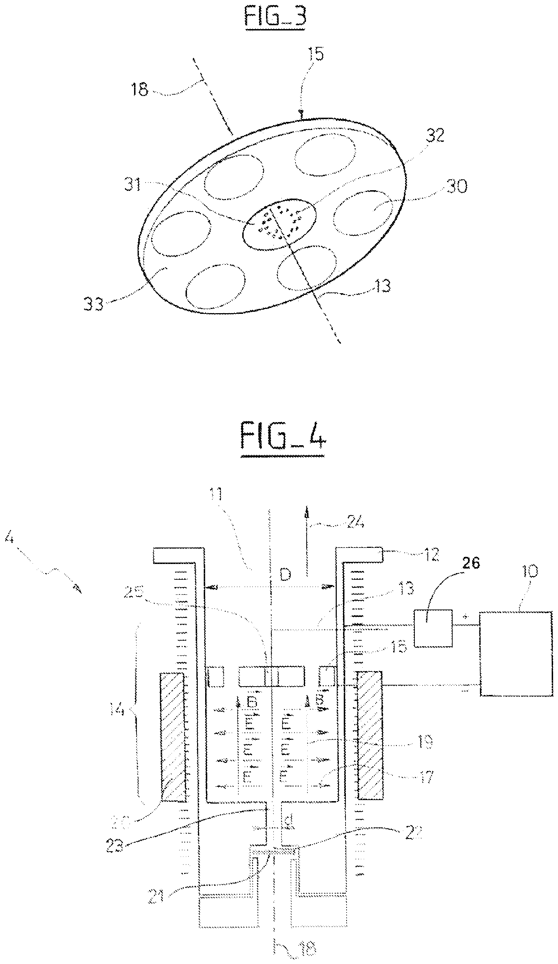

Cependant la lumière émise par le plasma devient d'autant plus faible que la pression des gaz à analyser dans l'enceinte **1** diminue. D'autre part le plasma est diffus sur toute la longueur de l'anode **13,** ce qui rend difficile la focalisation de la lumière émise sur le dispositif d'analyse **6.** La figure 3 montre en détail un mode de réalisation du disque **15** de la cathode **14** permettant de remédier à cet inconvénient.

La cathode **14** comprend un disque **15** percé d'une série de trous **30** traversants en périphérie formant un anneau entourant un trou central **31** également traversant. L'anode filaire **13** traverse le trou **31** en son centre. L'utilisation d'un disque **15** perforé permet la mise sous vide de cette partie de l'installation en libérant la circulation des molécules gazeuse.

Dans cet agencement, le plasma se localise à l'intérieur du trou central **31** du disque **15** sous la forme d'un anneau **32** de quelques millimètre de rayon centré sur l'axe **18** et entourant l'anode **13.** Le plasma localisé obtenu est beaucoup plus intense, et donc plus facilement focalisable sur le dispositif d'analyse **6.** Ainsi une analyse par spectrométrie d'émission optique peut être réalisée à des pressions très basses, inférieures à 10⁻³ mbar et même à 10⁻⁷ mbar.

Le champ magnétique B **19** se dispose le long des génératrices d'un cylindre de révolution centré sur l'axe **18** et passe de manière privilégiée par la matière constituant le disque **15,** ce qui le rend intense dans les parties pleines **33** du disque **15** et beaucoup plus faible dans les trous **30, 31** du disque **15.** L'utilisation d'un disque **15** augmente fortement et localement la valeur du champ électrique E **17** (jusqu'à le multiplier par cinq) et l'intensité du champ magnétique B **19** à l'intérieur du trou central **31.**

Lors de l'opération d'assemblage du dispositif d'ionisation **4** selon l'invention, le disque **15** de la cathode **14** est placée perpendiculairement aux parois **12** du volume **11** cylindrique. Le support **16** est fixé au-dessus du disque **15** de la cathode **14.** L'anode **13** est amenée par-dessus le disque **15** de la cathode **14,** et est emmanchée au centre du support **16** de manière à être perpendiculaire au plan du disque **15** et à se positionner au centre du disque **15** de la cathode **14.**

L'anode **13** doit être sensiblement centrée dans le trou central du disque. Dans le cas contraire l'anneau de lumière **32** ne se crée pas et la mesure est alors impossible à basse pression. Le centrage de l'anode **13** dans le disque **15** de la cathode **14** permet d'assurer également un parfait parallélisme entre l'anode **13** et les parois **12** du volume **11**.

On a illustré sur la figure 4 un autre mode de réalisation de l'invention. Les références de la figure 2 ont été conservées pour les éléments inchangés.

A l'intérieur du trou central du disque perforé **15** de la cathode **14,** correspondant à une zone de localisation privilégiée du plasma, l'intensité du champ électrique E **17** est très intense, et jusqu'à cinq fois plus intense que dans le reste du volume cylindrique **11.** L'intensité du champ électrique **17** à cet endroit est telle qu'il peut produire une pulvérisation de l'anode **13** à ce niveau. Ce risque est d'autant plus grand que la tension d'alimentation de l'anode **13** est supérieure à environ 3 000 volts. La pulvérisation de l'anode **13** fait apparaître sur le spectre d'émission optique une émission de lumière parasite sous la forme de raies de fortes largeurs spectrales qui ne correspondent pas aux espèces présentes dans l'enceinte sous vide. Ces raies parasites intenses peuvent en outre masquer les raies d'émission optiques caractéristiques des espèces présentes.

Pour éviter ce risque, l'anode **13** est isolée de la cathode **14** par un support **25** en matériau diélectrique qui est inséré dans le trou central du disque **15** perforé. Ainsi l'intérieur du trou central de la cathode **14** est neutralisé, et il n'y a plus de risque de pulvérisation de l'anode **13,** gênante pour la mesure spectrale. La suppression de cette zone a l'inconvénient de réduire légèrement l'émission de lumière émise par la source plasma. Mais la possibilité de pouvoir alimenter beaucoup plus fortement l'anode **13** permet de compenser largement la perte de lumière, et ainsi d'effectuer une mesure en temps réel (inférieur à une seconde).

Dans ce mode de réalisation il est donc nécessaire d'augmenter la tension d'alimentation des électrodes lorsque la pression des gaz à analyser est faible, de l'ordre de 10⁻⁷ mbars. Toutefois, l'application d'une telle tension est beaucoup trop importante lorsque la pression est plus élevée, supérieure à 10⁻⁵ mbar. L'intensité du plasma est alors telle que l'anode risque à nouveau de se pulvériser. De plus, les molécules craquées par le plasma contaminent très rapidement par dépôt le volume **11** contenant le plasma et les éléments optiques pouvant se trouver à proximité de celui-ci, et ce en moins de 24 heures. Pour conserver un avantage à n'importe quelle pression, un dispositif de régulation **26** de la tension d'alimentation de l'anode **13** est installé : lorsque la pression des gaz à analyser augmente, la tension d'alimentation de l'anode **13** est diminuée, et lorsque la pression diminue, la tension d'alimentation est augmentée. On obtient ainsi, quelle que soit la pression, un plasma suffisamment intense pour réaliser une mesure en temps réel, mais cependant suffisamment faible pour éviter toute contamination des éléments optiques. La durée de vie du système s'en trouve augmentée puisque la pollution par dépôt est fortement réduite. Cette régulation peut être corrélée à la mesure du courant d'ionisation généré dans la source plasma ou à la mesure de l'intensité du spectre, par exemple à l'aide d'un spectromètre d'émission optique. L'ajout d'une régulation permet d'obtenir un système pouvant fonctionner à des pressions beaucoup plus élevées, ce qui permettre d'effectuer une mesure spectrale dans une gamme de pression pouvant aller de 10⁻⁸ mbar à 1 mbar. La mesure du courant d'ionisation permet d'obtenir une mesure de la pression dans cette même gamme de pression de fonctionnement.

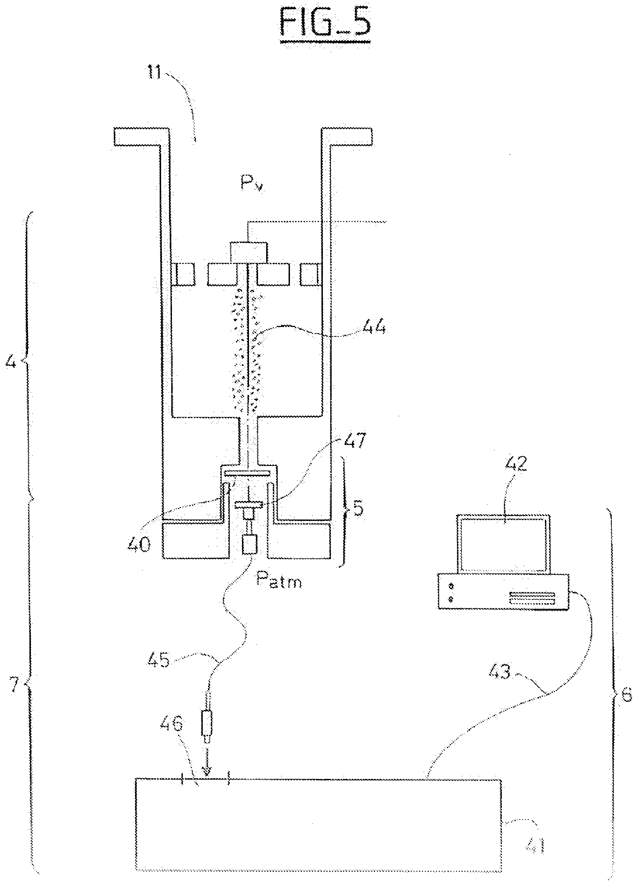

Comme représenté sur la figure 5, la lumière émise par le plasma qui traverse le hublot transparent **40,** est recueillie par le système collecteur optique **5** et analysée spectralement par un dispositif d'analyse **6.**

Le dispositif d'analyse **6** de la lumière émise par le plasma se compose d'un spectromètre d'émission optique (EOS) **41** associé à un ordinateur **42** reliés optiquement par une fibre **43** qui transporte la lumière du collecteur optique **5** vers le spectromètre **41.** De manière avantageuse, l'ordinateur **42** est placé avec le spectromètre d'émission optique **41** dans un même boîtier de manière à former un système de contrôle intégré compact. De cette manière la longueur des câbles de liaison entre l'ordinateur **42** et le spectromètre d'émission optique **41** est très courte, ce qui permet de garantir des temps d'analyse de gaz très court (<20 ms). Ce système de contrôle intégré interagit avec l'équipement de fabrication auquel il est relié en fonction des résultats de l'analyse de gaz. Ce système de contrôle peut, par exemple, arrêter le fonctionnement de l'équipement ou encore déclencher un système de purge de l'enceinte **1** à pression contrôlée.

Le dispositif d'ionisation **4** est environnée d'un vide secondaire et doit donc être séparée de la chaine d'acquisition optique **7** à la pression atmosphérique par une paroi transparente à la lumière. L'interface entre le milieu sous vide **11,** où est généré le plasma, et l'atmosphère extérieure est réalisée ici à l'aide du hublot transparent **40** muni de joints d'étanchéité qui se laisse traverser par la lumière. Le hublot **40** est de préférence placé au plus près de la zone d'émission de la lumière **44** issue du plasma afin d'optimiser sa détection.

Le collecteur optique **5** recueille la lumière émise par le plasma et la fait converger à l'extrémité d'une fibre optique **45,** l'autre extrémité de celle-ci étant reliée à l'entrée **46** du spectromètre d'émission optique **41.** Le collecteur optique **5** comprend ici au moins une lentille convergente **47** permettant de collecter la lumière émise par le plasma. Ces lentilles peuvent être simples (biconvexes, plan-convexes) ou achromatiques (permettant de s'affranchir des aberrations chromatiques et d'améliorer ainsi la focalisation).

L'axe optique du système collecteur optique **5** de la lumière et l'axe **18** de révolution des électrodes sont confondus. La distance focale du système optique est calculée pour être la plus petite possible afin d'optimiser la convergence, ce qui réduit par la même occasion l'encombrement total du système optique.

Pour améliorer la transmission sur une gamme précise de longueur d'onde, le hublot **40** et les lentilles **47** peuvent subir un traitement antireflets, par exemple par le dépôt d'une couche mince de MgF₂ destiné à améliorer la transmission sur la gamme 400-800 nm. Pour avoir une transmission optimum sur la plus large gamme de longueur d'onde possible, le hublot **40** et les lentilles **47** peuvent être réalisées en matériau de composition spéciale. Par exemple, on peut utiliser du fluorure de calcium ou encore de la silice fondue pour laquelle la transmission est supérieure à 90% sur la gamme 200-1000 nm.

Ainsi la chaîne d'acquisition optique **7** du système d'analyse de gaz **2** selon l'invention permet d'obtenir une mesure en temps réel (durée de mesure inférieure à 1 seconde).

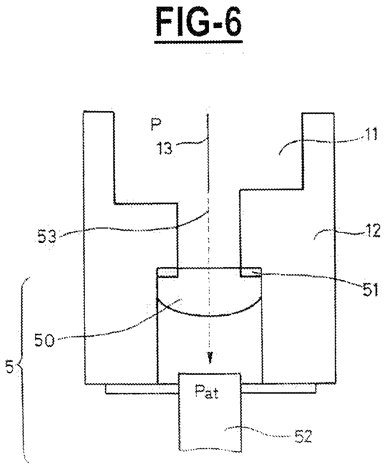

Dans le mode de réalisation représenté sur la figure 6, une des lentilles **50** composant le collecteur optique **5** peut permettre, si elle est mise en appui sur un joint **51,** d'éviter l'utilisation d'un hublot transparent, cette lentille **50** jouant elle-même le rôle d'interface séparatrice entre le vide et la pression atmosphérique. L'acheminement de la lumière depuis la sortie du collecteur optique **5,** qui est le point de focalisation de la lumière de la source plasma, vers l'entrée **46** du spectromètre **41** est réalisé par l'utilisation d'une fibre optique **52,** placée derrière la lentille **50,** qui recueille et conduit la radiation lumineuse **53.** La longueur de la fibre optique **52** est choisie la plus courte possible (ici environ 10 cm) afin de réduire au maximum les pertes optiques dans la fibre **52.**

Selon une variante de réalisation, le collecteur optique **5** de la lumière est un dispositif optique dont le point de convergence se situe à la fente d'entrée **46** du spectromètre **41.** Ce dispositif peut être constitué d'un ensemble de plusieurs lentilles **50,** ce qui permet d'améliorer la convergence. Dans ce cas la fente d'entrée **46** du spectromètre optique **41** est placée directement au point de convergence du faisceau de lumière **53.** Le guidage de la lumière jusqu'au spectromètre d'émission optique ne se fait pas au moyen d'une fibre optique, mais par focalisation directe du faisceau lumineux **53** sur la fente d'entrée **46,** les fibres optiques offrant une moins bonne transmission sur de larges gammes de longueur d'onde.

## Revendications

1. Système d'analyse de gaz à une pression de l'ordre d'un vide secondaire, comportant
- un dispositif d'ionisation des gaz (4) comportant une source de plasma comprenant
. une cathode (14) qui comprend des parois (12) conductrices délimitant un volume (11) cylindrique dans lequel est généré le plasma et un disque (15) comprenant au moins un trou central (31) traversant, et
. une anode (13) placée sensiblement au centre du trou, le plasma étant généré par l'action combinée d'un champ électrique (17) et d'un champ magnétique (19) orthogonal au champ électrique (17),
- un système collecteur (5) de la radiation lumineuse émise par le plasma,
- une cavité (23) cylindrique, placée entre le dispositif d'ionisation (4) et le système collecteur (5), adjacente au volume (11) cylindrique et coaxiale à l'anode (13), ayant une conductance moindre que ledit volume (11) cylindrique et étant exempte de champ électrique (17) et magnétique (19), l'extrémité de la cavité (23) opposée au volume (11) cylindrique étant fermée par un hublot (21) ou par une lentille (50) transparents à la radiation lumineuse émise par le plasma, et
- un dispositif d'analyse (6) des gaz ionisés comprenant un spectromètre optique (41) pour analyser l'évolution du spectre de la radiation lumineuse émise par le plasma.

2. Système selon la revendication 1, dans lequel la cathode (14) comporte ledit disque (15) perforé comprenant des trous traversants périphériques (30) entourant le trou central (31) traversant.

3. Système selon l'une des revendications 1 et 2, dans lequel le diamètre d de la cavité (23) est moindre que le diamètre D du volume (11) cylindrique, le diamètre d étant ajustable en fonction de la pression des gaz à analyser.

4. Système selon l'une des revendications précédentes, dans lequel l'anode (13) est isolée de la cathode (14) par un support (25) en matériau diélectrique inséré dans le trou central (31) du disque (15) de la cathode (14).

5. Système selon la revendication 4, comportant en outre un dispositif de régulation permettant d'asservir la tension d'alimentation de l'anode (13) à la variation de pression des gaz à analyser.

6. Système selon l'une des revendications précédentes, dans lequel le système collecteur (5) comporte au moins une lentille (47) convergente dont l'axe optique est confondu avec l'axe (18) des électrodes (13, 14).

7. Système selon l'une des revendications précédentes, dans lequel la cavité (23) est disposée à l'extrémité du volume (11) cylindrique de manière à ce que le trajet de la radiation lumineuse qui la traverse soit de même direction et de sens opposé au flux des gaz pompés.

8. Équipement de fabrication de semi-conducteurs par plasma comprenant au moins une enceinte (1) contenant des gaz maintenus sous vide secondaire et un système d'analyse (2) de gaz selon l'une des revendications précédentes auquel l'enceinte est reliée, l'équipement comportant en outre un ordinateur (42), **caractérisé en ce que** le spectromètre optique (41) et l'ordinateur (42) sont placés dans un boîtier commun de manière à constituer un système de contrôle intégré compact, et reliés à l'équipement afin d'interagir avec lui en fonction des résultats de l'analyse de gaz.

## Patentansprüche

1. Analysesystem von Gas auf einem Druck in der Größenordnung eines Sekundärvakuums, das aufweist
- eine Gasionisationsvorrichtung (4), die eine Plasmaquelle aufweist, die enthält
. eine Kathode (14), die leitende Wände (12), die ein zylindrisches Volumen (11) begrenzen, in dem das Plasma erzeugt wird, und eine Scheibe (15) enthält, die mindestens ein zentrales Durchgangsloch (31) enthält,
und
. eine Anode (13), die im Wesentlichen in der Mitte des Lochs angeordnet ist,
wobei das Plasma durch die kombinierte Wirkung eines elektrischen Felds (17) und eines magnetischen Felds (19) orthogonal zum elektrischen Feld (17) erzeugt wird,
- ein Kollektorsystem (5) der vom Plasma emittierten Lichtstrahlung,
- einen zylindrischen Hohlraum (23), der zwischen der Ionisationsvorrichtung (4) und dem Kollektorsystem (5) dem zylindrischen Volumen (11) benachbart und koaxial zur Anode (13) angeordnet ist, mit einer geringeren Leitfähigkeit als das zylindrische Volumen (11) und ohne elektrisches (17) und magnetisches Feld (19), wobei das Ende des Hohlraums (23) entgegengesetzt zum zylindrischen Volumen (11) von einem Sichtfenster (21) oder von einer Linse (50) verschlossen wird, die für die vom Plasma emittierte Lichtstrahlung durchlässig ist, und
- eine Analysevorrichtung (6) der ionisierten Gase, die ein optisches Spektrometer (41) enthält, um die Entwicklung des Spektrums der vom Plasma emittierten Lichtstrahlung zu analysieren.

2. System nach Anspruch 1, wobei die Kathode (14) die Lochscheibe (15) aufweist, die periphere Durchgangslöcher (30) enthält, die das zentrale Durchgangsloch (31) umgeben.

3. System nach einem der Ansprüche 1 und 2, wobei der Durchmesser d des Hohlraums (23) geringer als der Durchmesser D des zylindrischen Volumens (11) ist, wobei der Durchmesser abhängig vom Druck der zu analysierenden Gase einstellbar ist.

4. System nach einem der vorhergehenden Ansprüche, wobei die Anode (13) von der Kathode (14) durch einen Träger (25) aus dielektrischem Material isoliert ist, der in das zentrale Loch (31) der Scheibe (15) der Kathode (14) eingefügt ist.

5. System nach Anspruch 4, das außerdem eine Regelungsvorrichtung aufweist, die es ermöglicht, die Speisespannung der Anode (13) an die Druckänderung der zu analysierenden Gase anzupassen.

6. System nach einem der vorhergehenden Ansprüche, wobei das Kollektorsystem (5) mindestens eine konvergierende Linse (47) aufweist, deren optische Achse mit der Achse (18) der Elektroden (13, 14) zusammenfällt.

7. System nach einem der vorhergehenden Ansprüche, wobei der Hohlraum (23) am Ende des zylindrischen Volumens (11) so angeordnet ist, dass der Pfad der Lichtstrahlung, die ihn durchquert, die gleiche Richtung hat und entgegengesetzt zum Fluss der gepumpten Gase verläuft.

8. Ausrüstung zur Herstellung von Halbleitern durch Plasma, die mindestens einen Raum (1), der unter Sekundärvakuum gehaltene Gase enthält, und ein Gasanalysesystem (2) nach einem der vorhergehenden Ansprüche enthält, mit dem der Raum verbunden ist, wobei die Ausrüstung außerdem einen Computer (42) aufweist, **dadurch gekennzeichnet, dass** das optische Spektrometer (41) und der Computer (42) in einem gemeinsamen Gehäuse angeordnet sind, um ein kompaktes integriertes Steuersystem zu bilden, und mit der Ausrüstung verbunden sind, um mit ihr abhängig von den Ergebnissen der Gasanalyse zu interagieren.

## Claims

1. System for analysing a gas having a pressure of the order of a secondary vacuum, including:
- a device for ionizing gases (4) including a plasma source comprising
• a cathode (14) which comprises conductive walls (12) defining a cylindrical volume (11) in which the plasma is generated and a disc (15) comprising at least one central through-hole (31),
and
• an anode (13) placed substantially in the centre of the hole, the plasma being generated by the combined action of an electric field (17) and a magnetic field (19) that is orthogonal to the electric field (17);
- a system for collecting (5) the luminous radiation emitted by the plasma;
- a cylindrical cavity (23), placed between the ionizing device (4) and the collecting system (5) adjacent to the cylindrical volume (11) and coaxial with the anode (13), having a conductance that is less than said cylindrical volume (11) and being free of any electric (17) or magnetic (19) field, the end of the cavity (23) opposite the cylindrical volume (11) being closed off by a window (21) or by a lens (50) which are transparent to the luminous radiation emitted by the plasma; and
- a device for analysing (6) ionized gases comprising an optical spectrometer (41) for analysing the variation in the spectrum of the luminous radiation emitted by the plasma.

2. System according to Claim 1, wherein the cathode (14) includes said perforated disc (15) comprising peripheral through-holes (30) surrounding the central through-hole (31).

3. System according to either of Claims 1 and 2, wherein the diameter d of the cavity (23) is smaller than the diameter D of the cylindrical volume (11), the diameter d being adjustable according to the pressure of the gases to be analysed.

4. System according to one of the preceding claims, wherein the anode (13) is insulated from the cathode (14) by a support (25) made of a dielectric material inserted into the central hole (31) of the disc (15) of the cathode (14).

5. System according to Claim 4, further including a regulating device allowing the supply voltage of the anode (13) to be feedback-controlled according to the variation in the pressure of the gases to be analysed.

6. System according to one of the preceding claims, wherein the collecting system (5) includes at least one converging lens (47), the optical axis of which is merged with the axis (18) of the electrodes (13, 14).

7. System according to one of the preceding claims, wherein the cavity (23) is positioned at the end of the cylindrical volume (11) so that the path of the luminous radiation passing therethrough is in the same direction and opposite the flow of pumped gases.

8. Device for fabricating semiconductors using plasma, comprising at least one chamber (1) containing gases held under secondary vacuum and a gas analysis system (2) according to one of the preceding claims to which said chamber is linked, the device further including a computer (42), **characterized in that** the optical spectrometer (41) and the computer (42) are placed in a common housing so as to constitute a compact integrated control system, and are linked to the device so as to interact therewith according to the results of the gas analysis.
